# EUROPEAN PATENT SPECIFICATION

(11) **EP 2 053 670 B1**
(45) Date of publication and mention of the grant of the patent: **19.12.2012**
(21) Application number: 07119061.5
(22) Date of filing: 23.10.2007
(51) Int. Cl.: H01L 41/053, H01L 41/09, B64C 3/38

(54) **An elongated actuator structure**
Längliche Aktorstruktur
Structure d'actionneur allongée

(43) Date of publication of application: 29.04.2009
(73) Proprietor: Universität Potsdam, 14469 Potsdam (DE)
(72) Inventor: Kofod, Guggi, 10961, Berlin (DE); Bauer, Siegfried, 4040, Linz (AT); Paajanen, Mika, 33720, Tampere (FI)
(74) Representative: Hengelhaupt, Jürgen

(56) References cited:
- EP-A- 0 370 508
- EP-A- 1 748 190
- US-A1- 2003 218 403
- US-A1- 2005 200 238
- US-A1- 2005 230 546
- PELRINE R ET AL: "Dielectric elastomer artificial muscle actuators: toward biomimetic motion" SMART STRUCTURES AND MATERIALS 2002: ELECTROACTIVE POLYMER ACTUATORS AND DEVICES (EAPAD), SAN DIEGO, CA, USA, 18-21 MARCH 2002; PROCEEDINGS OF SPIE, vol. 4695, 2002, pages 126-137, XP002478016 ISSN: 0277-786X
- KOFOD G ET AL: "New design concept for dielectric elastomer actuators" SMART STRUCTURES AND MATERIALS 2006: ELECTROACTIVE POLYMER ACTUATORS AND DEVICES (EAPAD), SAN DIEGO, CA, USA, 27 FEB - 2 MAR 2006; PROCEEDINGS OF SPIE, vol. 6168, 2006, XP002478044 ISSN: 0277-786X

## Description

### Field of the Invention

The present invention relates generally to an elongated actuator structure and to a method for producing such a device. More particularly, the present invention relates to electro-active polymers inside an elongated actuator structure.

In engineering, actuators are frequently used as mechanisms to introduce motion. The prior art teaches many different solutions with regard to shape and functionality of such actuators. The actuating elements used to convert electrical into mechanical energy often require high driving voltages which may be harmful to the user. At the same time, many types of actuating elements are mechanical structures which are not very robust. Therefore, the need arises to provide a mechanism to protect both, the actuating elements acting within the actuator and the user of the actuator.

Much attention has recently been drawn to electroactive polymers, which are capable of converting electrical energy to mechanical energy, and vice versa, and which are now available for wide range of energy conversion applications. One class of these polymers, electroactive elastomers, also called dielectric elastomers, electroelastomers or EPAM, is gaining particular attention. Dielectric elastomers may exhibit high energy density, stress, and electromechanical coupling efficiency.

Dielectric elastomer actuators are commonly fragile, since they are made of thin films of soft elastomer. It is well-known that the performance of those structures is increased when they are pre-strained.

The prior art teaches solutions which provide the required pre-strain in structures which are capable of storing elastic energy, using mechanical springs or at least emulating the effect of a spring mechanism. In some of those known devices, the actuator film is stretched between beams of a flat flexible frame which acts as a spring, see e.g. US 2003/218403 A1. As a result of the forces on the frame applied by the actuating films, a complex structure may form which fulfils the condition of minimum potential energy. Upon activation of the actuating film, the complex structure may reshape in a way to restore the original structure of the (elastic) flat frame. Those arrangements also provide structural protection of the device against so-called pull-in failure, which occurs when mechanical stress and electrostatic stress cancel, leading to an accelerating expansion of the film until it may be ripped apart.

In other known devices, a highly pre-strained elastomer film is rolled onto a central compression spring which allows for the performance of axial extension and bending of the structure.

A limitation of the previous solutions mentioned above is that direct access to the actuating film from the outside is possible, which poses the risk that the film may be damaged or a user may come into contact with high voltages which are required to operate the actuator.

It is an object of the invention to provide an actuator which represents an inherent mechanical protection of the actuating elements which carry out the motion and at the same time guarantee the safety of the user of such actuator.

### A Summary of the Invention

The present invention overcomes limitations in the prior art. An elongated actuator according to one aspect of the present invention comprises an elongated frame member and at least one actuating element inside the frame member, the actuating element being adapted to deform the frame member according to claim 1. Since the frame member is not flat (e.g. essentially two-dimensional) but elongated, it encapsulates the at least one actuating element and thus prevents direct mechanical interaction between the actuating element and the outside of the frame member. Hereby the arrangement provides a high degree of protection both for the elements integrated in the elongated structure and for the user of the actuator who might otherwise come into direct contact with electrically charged parts of the structure.

The elongated frame member may extend in a first direction. However, the invention is not limited to that, as the elongated frame member may also be curved or bent, as long as it effectively encapsulates the actuating element.

The frame member may comprise at least one portion made of an elastic material, the actuating element being adapted to deform said portion, whereby the frame member may act as a spring and may exert a spring bias onto the actuating element.

The frame member is adapted to switch between at least two states, wherein the frame member releases elastic energy when switching from a first to a second state and stores elastic energy when switching from the second to the first state, and wherein the actuating element is adapted to cause a transition between the at least two states. The invention is not limited to only two states. The frame member may adopt various shapes and carry out different movements. Also, if several actuating elements are provided inside the frame member, they may be actuated independently from one another, thus increasing the degrees of freedom of the actuator. However, each actuating element is adapted to communicate between different states of the frame member which differ in the amount of elastic energy stored in the frame member.

The actuating element is in an inactivated state, when the frame member is in the first state, and is in an activated state, when the frame member is in the second state. In this embodiment, there is a ground state of the structure in which elastic energy is stored in the frame member (e.g. when the voltage applied to the actuating element is zero, or the dimensions of the actuating element are minimised), and there is an excited state of the structure in which a smaller amount or no elastic energy is stored in the frame member (e.g. when a voltage is applied to the actuating element and/or the dimensions of the actuating element are increased).

In a preferred embodiment of the invention, the actuating element is adapted to deform the frame member in a second direction perpendicular to the first direction. However, the deformation may also occur in a third direction perpendicular to the first and second directions. In general, any reshaping of the cross-section of the frame member (when cut perpendicularly to the first direction) is conceivable.

The frame member may comprise an external wall, the actuating element being adapted to apply a force onto an inner surface of the external wall. The actuating element may apply a force onto opposing surfaces of the external wall, e.g. when the external wall forms a closed structure. However, the actuating element may also apply a force onto one portion of the surface of the external wall only, e.g. when the opposing end of the actuating element is mechanically bonded to rigid parts of the frame member, e.g. a central rod or plate inside the frame member.

Various shapes of the actuating element are practical. It may be provided in the shape of a string or in the form of an actuating sheet.

A plurality of actuating elements may be provided inside the frame member which may be identical in form, shape and/or functionality. Also, they may differ in those properties, e.g. when an actuating string and an actuating film are provided at the same time. The plurality of elements may be adapted to actuate in synchronisation, e.g. when each portion of the frame member is to be deformed in a similar fashion. However, they may also actuate independently from one another, e.g. when different cross-sections of the frame member are to be obtained in different regions, at the same time.

The frame member may have an elliptical cross section in the first state and a circular cross section in the second state. An important example for this embodiment is the case of an elastic tube, e.g. a plastic tube. This kind of tube may be obtained by bending a plastic sheet (e.g. made of Polyethylenterephthalat or PET) and mechanically bonding the shorter sides thereof. An alternative solution is an extruded tube with walls thin enough so that they are deformable. When an actuating element, e.g. which is pre-stretched, is integrated in such a tube in such a fashion that it applies different amounts of forces/stresses in at least two different directions onto the inner surfaces of the tube, in particular when it applies forces/stresses onto the inner surfaces only along one direction, the shape of the tube may altered so that its cross-section is an ellipse. When the actuating element releases the forces applied to the inner surfaces or applies same amounts of forces/stresses in the at least two different directions onto the inner surfaces of the tube, the tube reshapes itself due to its elastic nature so that its cross-section reassumes a circular shape.

Various other shapes of the frame member are also practical. E.g., the frame member may have a rectangular cross section in at least one of the states. The frame member may also have an elliptical cross-section elongated in a certain direction in the absence of the actuating element, and the insertion of a pre-strained actuating element may reshape the cross-section of the frame member into an ellipse which is elongated in a perpendicular direction. In this case, the frame member may switch between two elliptical states.

When an actuating sheet or a plurality of actuating sheets are used as (an) actuating element(s), it (or each of them, or some of them) may extend in the first direction or may extend perpendicularly to the first direction.

The actuating element may comprise a pre-stretched dielectric elastomer actuator. In this case, the technical advantages of the present invention include protecting the fragile material from external manipulations, protecting the surroundings, e.g. the user, from dangerous high voltages (10-100 kV) which are required to drive the elastomer actuator, as well as providing a practical solution to spring-bias the elastomer actuator, the frame member, e.g. plastic tube, acting as such a spring-loading device. Also, the movement of the actuating element can be carried out without the need of sliding parts or metal parts.

In the first state, no voltage may be applied to the dielectric elastomer actuator, and in the second state, a voltage may be applied to the dielectric elastomer actuator for releasing the strain inside the dielectric elastomer. That in turn releases elastic energy stored in the frame member. E.g., the cross-section of an elastic tube may alter its shape from elliptical to circular.

However, the present invention is not limited to the use of dielectric elastomer actuators. The benefits of the invention are also achieved for any other active material which is adapted to convert electrical into mechanical energy and in particular for any arrangements which are pre-strained and which are adapted to release that strain. Examples are shape memory polymers, electroactive gels or shape memory metals/alloys like NiTi, CuZnAl or CuAlNi. In the latter class, temperature changes may cause a phase transition which results in a change of strain inside the material.

According to another aspect of the present invention, an elongated structure comprises at least one elongated actuator according to the invention. The elongated structure may comprise an outer tube in which the at least one elongated actuator is situated. Alternatively, the elongated structure may be wing-shaped and may comprise a wing portion in which the at least one elongated actuator is situated and which is adapted to be deformed by the at least one elongated actuator.

According to another aspect of the present invention, an elongated actuator according to the invention is used in aerodynamics or hydrodynamics.

According to another aspect of the present invention, a method of producing an elongated actuator according to claim 19 is provided, which comprises the steps of providing an elongated frame member, extending in a first direction, and integrating an actuating element inside the frame member so that it is adapted to deform the frame member, and encapsulates the actuating element.

The actuating element is pre-stretched prior to being integrated inside the frame member.

The frame member may be a tube made at least partially of an elastic material, and upon inserting the pre-stretched actuating element, the frame member may adopt an elliptical cross-section.

### Embodiments

These and other features and advantages of the present invention will be described in the following description of the invention and associated figures, in which:
- Figure 1: schematically shows the actuating mechanism of dielectric elastomers,
- Figure 2: shows a first embodiment of the present invention,
- Figure 3 a, b: shows a second embodiment of the present invention,
- Figure 4: shows a third embodiment of the present invention,
- Figure 5: shows a fourth embodiment of the present invention,
- Figure 6 a-c: shows a alternative shapes of the frame member,
- Figure 7: shows an alternative shape of an actuating sheet,
- Figure 8 a-c: show an elongated structure comprising an elongated actuator,
- Figure 9: shows a hydrodynamic pump comprising an elongated actuator,
- Figure 10: shows a wing structure comprising a series of elongated actuators.

The present invention is described in detail with reference to a few preferred embodiments as illustrated in the accompanying drawings. In the following description, numerous specific details are set forth in order to provide a thorough understanding of the present invention.

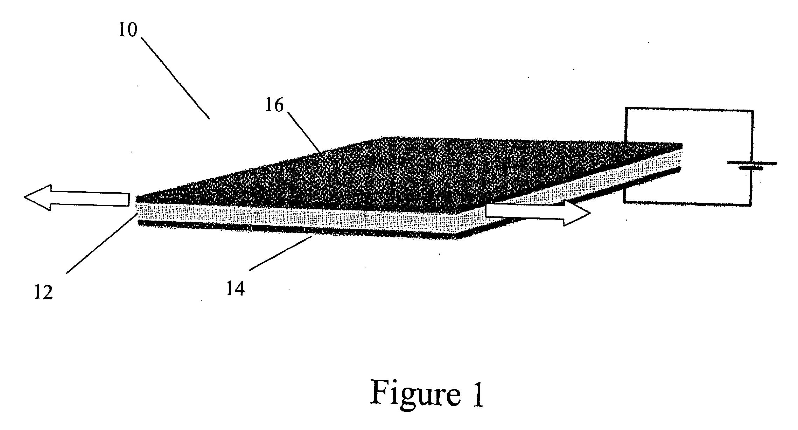

Figure 1 schematically shows the actuating mechanism of dielectric elastomers.

An dielectric elastomer sheet 12 is situated between two compliant electrodes 14,16, which are coated on both sides of the dielectric elastomer sheet 12.

The dielectric elastomer sheet 12 is an insulating layer, so that charges on the communicating electrodes 14, 16 do not travel into the polymer material.

When a voltage is applied to the electrodes 14, 16, opposite charges are generated on the electrodes 14,16, which causes an attractive force between the electrodes 14,16 which in turn creates a compressive pressure on the insulating elastomer sheet 12. The insulating elastomer sheet 12 is squeezed by the pressure, whereby it is deformed and decreases in thickness while expanding in planar directions indicated by the arrows. This area expansion can be used to actuate mechanical systems. The individual sheets may be layered to increase actuation forces. The deformation can be very large if the insulating elastomer sheet 12 is preloaded, preferably by a spring mechanism.

The dielectric elastomer sheet 12 and the electrodes 14,16 together form an actuating film 10.

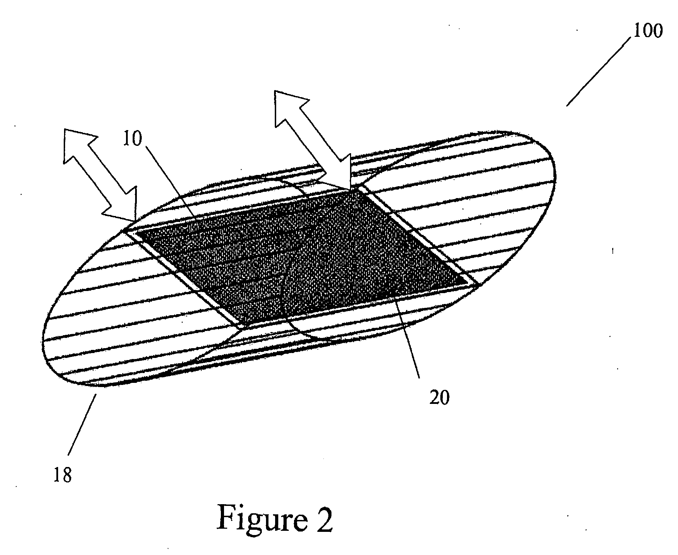

Figure 2 shows a first embodiment of the present invention. The actuating film 10 is pre-stretched and situated inside a closed tube 18. The tube 18 is made of elastic material, e.g. Polyethylenterephthalat (PET), or even metal if the electricity is shielded appropriately. The tube 18 completely encloses and encapsulates the actuating film 10. The central axis of the tube 18 lies in the plane of the actuating film 10. Edges 20 of the actuating film 10 are connected to the inner walls of the tube 18. The edges 20 may be glued onto the surfaces of the inner walls or they might be indirectly mechanically connected by virtue of other mechanical parts. If no voltage is applied to the actuating film 10, the actuating film 10 pulls at inner walls of the tube 18, in a fashion to produce an elliptical cross-section. This corresponds to a first state (ground state) of the tube, in which the tube stores elastic energy.

In absence of the actuating film 10, the tube 18, which is made of a homogeneous material, would be symmetrical and have a circular cross-section. The tube reassumes the latter shape (or is deformed in a way that its shape is closer to that shape) when a voltage is applied to the actuating film 10, which releases the stress inside the actuating film 10. As a result, the actuating film 10 expands in its plane and the forces exerted on the inner walls of the tube 18 (and directed inwards) decrease, whereby the walls of the tube 18 move to the outside by virtue of the elasticity of the tube 18. This corresponds to a second state (excited state) of the tube. During the transition from first to second state, the elastic energy stored in the tube is released.

The strain inside the actuating film 10 may never be fully released so that the forces exerted on the inner walls of the tube 19 never vanish and the tube never reassumes the shape in which its cross-section is circular. In this case, the tube never releases all the elastic energy stored.

The tube 18 acts as a spring bias and as a strong protection of the fragile dielectric elastomer sheet 12 from direct access from the outside. It also acts as a further protection against pull-in failure of the dielectric elastomer sheet 12.

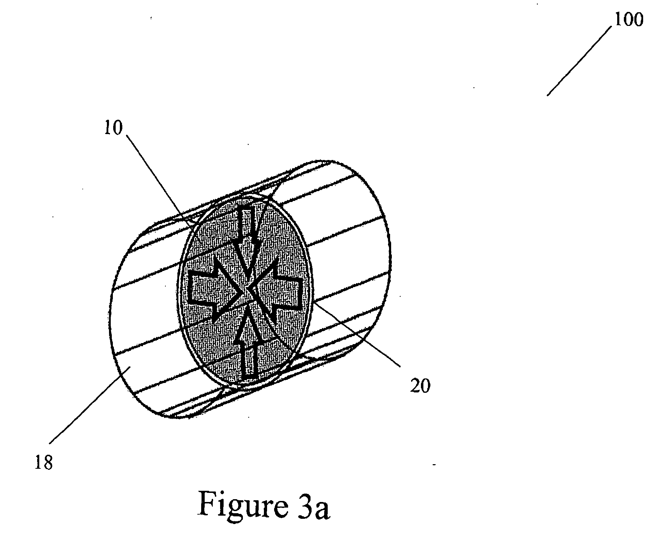

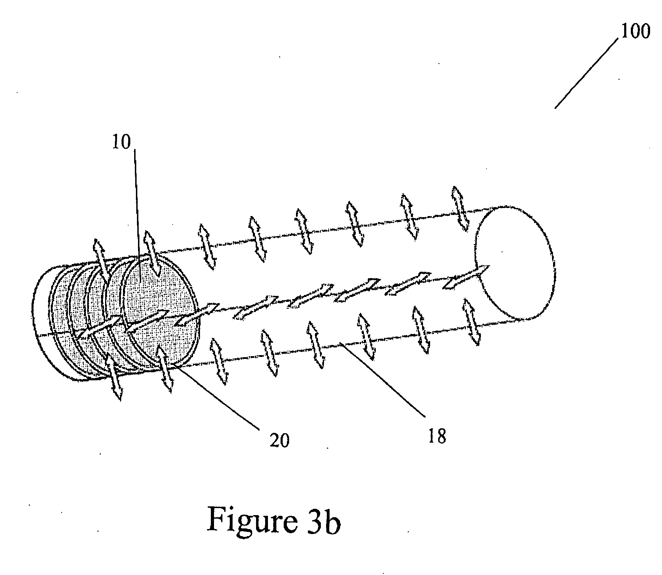

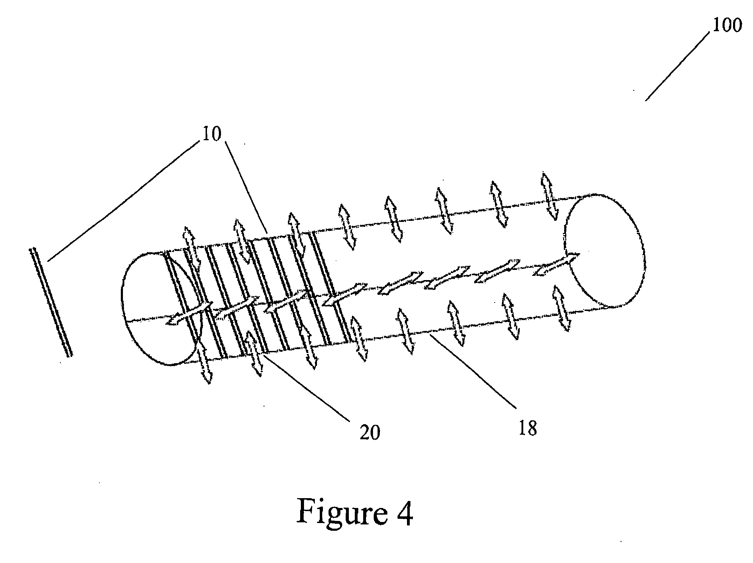

The arrangement depicted in Figure 2 forms as a whole an elongated actuator 100. (The same applies to Figures 3 and 4.)

Figure 3a shows a second embodiment of the present invention, in which the actuating film 10 is placed perpendicularly to the central axis of the tube 18. The pre-stretches inside the actuating film 10 are different along perpendicular major axes (indicated by the arrows), which accounts for the elliptical cross-section of the tube 18 in its first state. Upon activation of the actuating film 10, the forces on the inner walls of the tube 18 decrease. As they decrease, the tube 18 releases the stored elastic energy and carries out a transition in its second state (excited state), in which its cross-section is circular.

Figure 3b shows the second embodiment of the present invention in which a plurality of actuating films 10 is placed perpendicularly to the central axis of the tube 18. In this geometry, the tube 18 may be packaged very densely. A plurality of actuating films 10 can be stacked as multiple layers which leads to a very compact and strong actuator 100. Each of the actuating films 10 can be controlled independently from one another or in synchronisation. A main conducting bus (not shown) is provided along the length of the tube 18 for providing electrical energy to the actuating films 10.

Figure 4 shows a third embodiment of the present invention in which the actuating element 10 is provided in the shape of a string. Forces are applied to the inner walls of the tube only along one direction. The deformation mechanism and the corresponding mechanical states of the tube 18 are equivalent to those in Figure 3. Stacked bundles of string-like or fiber-like actuating elements 10 may be provided inside the tube 18. Again, each of the string-like or fiber-like actuating elements 10 can be controlled independently from one another or in synchronisation.

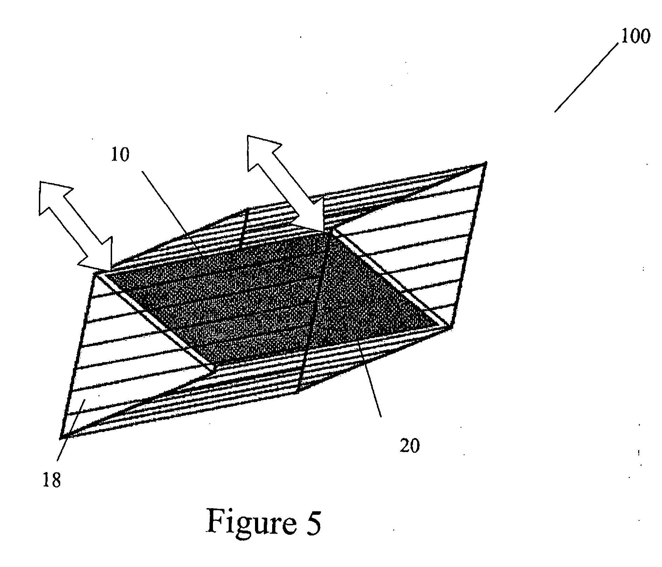

Figure 5 shows a fourth embodiment of the present invention, in which the frame member 18 has a rectangular cross section (or a cross-section in the shape of a parallelogram) in at least one of its mechanical states. The system may switch between different cross-sections pertaining to parallelograms with different angles between their sides according to the degree of activation of the actuating film 10.

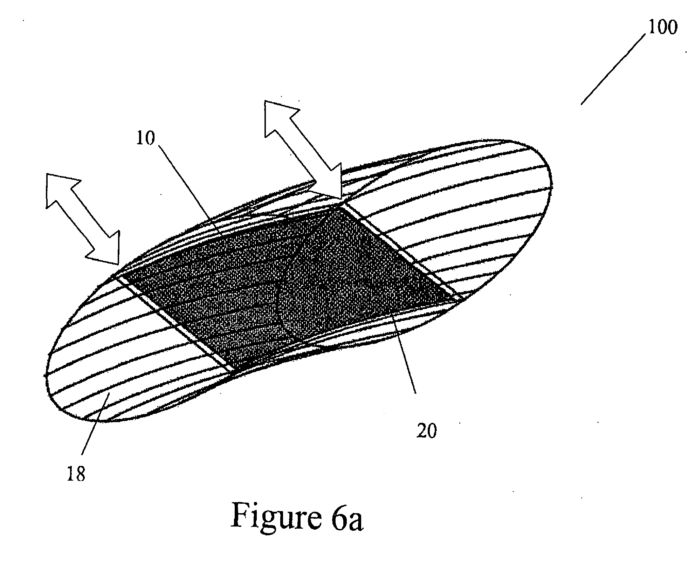

Figure 6a shows a bent frame member 18 and illustrates that the invention is not limited to frame members which are straight and extend in one direction. The frame member 18 may also be elongated and may encapsulate the actuating film 10 when it is bent or curved. The frame member may even be doughnut-shaped.

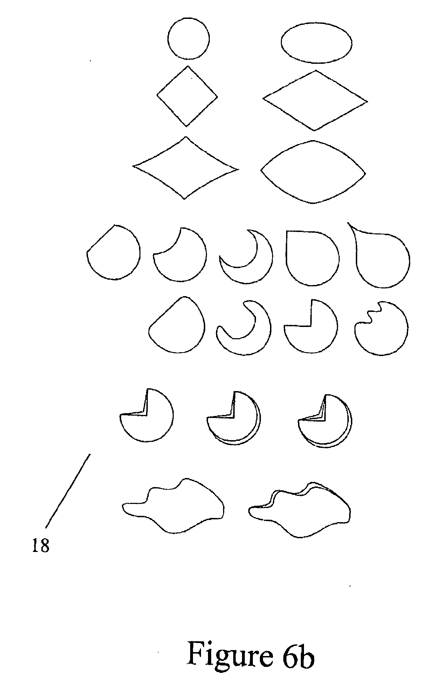

Figure 6b shows different possible shapes of the cross-section of the frame member 18 and illustrates that the invention is not limited to frame members which have simple circular, elliptical or rectangular cross-sections. Figure 6b (below) also illustrates that the frame member 18 does not have to have uniform thickness but may be provided with additional layers at its exterior to locally modify its stiffness and/or its mechanical properties.

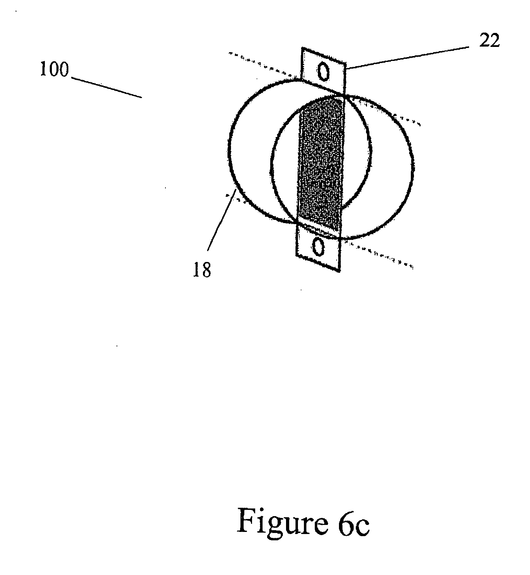

Figure 6c illustrates that the frame member 18 may be provided with handles 22 at its exterior which allow for better handling of the actuator 100, e.g. easier integration of the actuator 100 in various mechanical structures. The handles 22 may be positioned at opposing sides of the frame member 18, but the invention is not restricted thereto.

In all embodiments shown the actuating element 10 may be bonded to the inner walls of the tube using a bonding agent, e.g. glue. However, the mechanical connection may not be direct but rely on connecting the actuating element 10 to additional beams or fins inside the tube 18, or, more generally, inside the frame member. The actuating element 10 may also be biased in a preframe before being inserted inside the frame member, which allows for a simplified manufacture of the actuator 100.

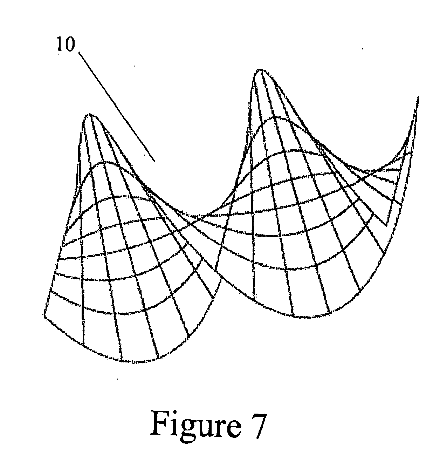

Figure 7 shows an alternative shape of the actuating film 10, which is not restricted to basic forms such as strings or sheets. In Figure 7, the actuating film 10 has a helicoid shape and does not lie in one plane. Edges 20 of the actuating film 10 touch inner walls of the frame member 18 with a helical symmetry.

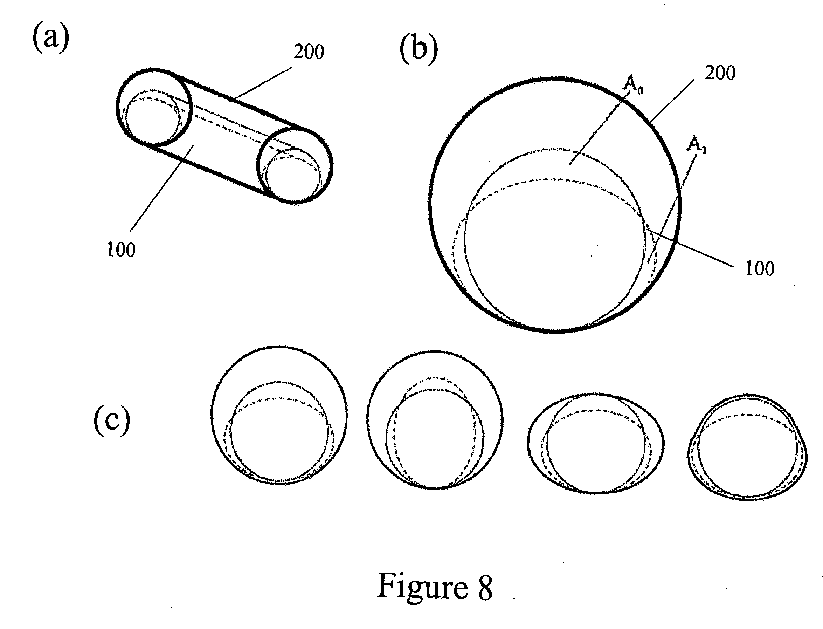

Figure 8a shows an elongated structure in perspective view comprising an outer tube 200, in which an elongated actuator 100 is situated. When the elongated actuator 100 switches between different states represented by different shapes of its cross-section (A₀ and A₁ in Figure 8b), the area of the cross-section taken up by the elongated actuator 100 varies. If the outer tube is rigid, the area of the cross-section of the outer tube excluding that of the elongated actuator 100 also varies and thus also the corresponding volume of the elongated structure. Figure 8c shows different shapes of cross-sections of the outer tube 200 and the elongated actuator 100, which can be provided depending on their initial shapes and on the rigidity of the outer tube 200.

The variation in volume can be used to apply pressure on a liquid in the elongated structure (placed in the interior of the outer tube 200 and in the exterior of the elongated actuator 100).

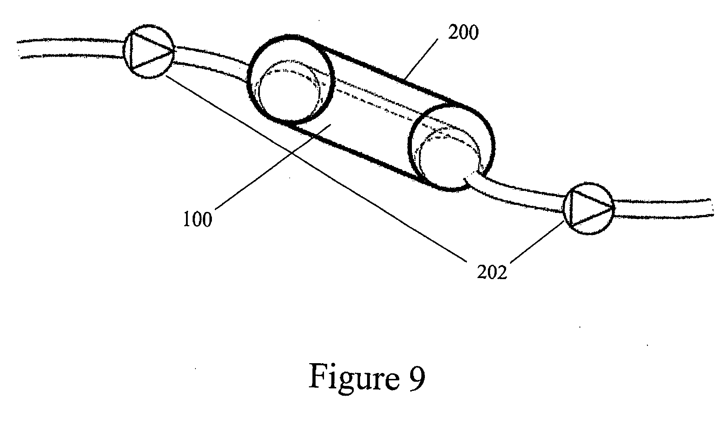

Figure 9 shows a hydrodynamic pump making use of this effect. Valves 202 are provided at the ends of the elongated structure, thus allowing a liquid to flow in a pre-determined direction. When the elongated actuator 100 changes its shape, the pressure on the liquid varies, e.g. is raised thus pushing the liquid through one of the valves 202 (or is lowered thus pulling liquid through the other one of the valves 202).

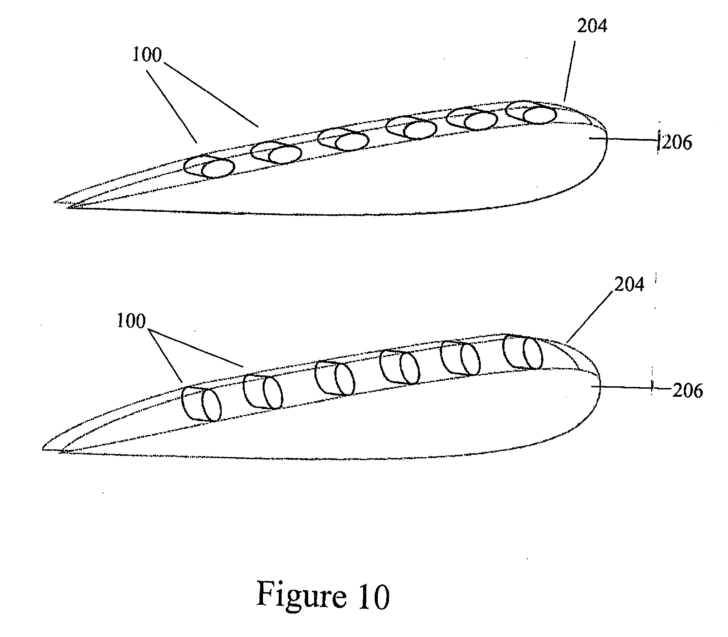

Figure 10 shows a part of a wing structure comprising a series of elongated actuators. An elongated structure 206 is wing-shaped and comprises a wing portion (204), in which a series of elongated actuators 100 are situated and which is adapted to be deformed by a series of elongated actuators 100. Thereby, the cross-section of the wing structure may be modified. (Figure 10 shows only a part cut from the elongated structure).

Potential applications of the actuator 100 in its different forms and embodiments are manifold. The invention is a versatile, safe actuator, which can have different uses such as in robots, orthopedic assists, toys, industrial production, manufacturing, locomotion and space exploration as well as vibration suppression and damping (e.g. in a scaffolding device adapted to absorb vibrations). Also, oscillating voltages may be applied to the actuating elements 10, thereby providing an oscillating mechanical structure. A very long tube can be provided, which has a changeable profile, which can be used to enhance flow or to agitate a reacting fluid (e.g. in the dairy industry or chemical industry).

### List of references

- 100: elongated actuator (100)
- 10: actuating element (film, string)
- 12: dielectric elastomer film
- 14, 16: electrodes
- 18: tube/frame member
- 20: mechanical connection between actuating element and frame member
- 22: handles
- 200: outer tube
- 202: valves
- 204: wing portion
- 206: wing structure

## Claims

1. An elongated actuator (100), comprising:
• a frame member (18), the frame member (18) being adapted to switch between at least two states, wherein the frame member (18) releases elastic energy when switching from a first to a second state and stores elastic energy when switching from the second to the first state;
• at least one actuating element (10) inside the frame member (18), the actuating element (10) comprising a pre-strained material and being adapted to deform the frame member (18) and to cause a transition between the at least two states, wherein the actuating element (10) is in an inactivated state, when the frame member (18) is in the first state, and is in an activated state, when the frame member (18) is in the second state,
**characterised in that** the frame member (18) is elongated so as to encapsulate the at least one actuating element (10).

2. The elongated actuator (100) according to claim 1, **characterised in that** the frame member (18) extends in a first direction.

3. The elongated actuator (100) according to claim 1 or 2, **characterised in that** the frame member (18) comprises at least one portion made of an elastic material, the actuating element (10) being adapted to deform said portion (18).

4. The elongated actuator (100) according to any one of claims 2-3, **characterised in that** the actuating element is adapted to deform the frame member (18) in a second direction perpendicular to the first direction.

5. The elongated actuator (100) according to any one of the preceding claims, **characterised in that** the frame member (18) comprises an external wall, the actuating element (10) being adapted to apply a force onto an inner surface of the external wall.

6. The elongated actuator (100) according to any one of the preceding claims, **characterised in that** the actuating element (10) is provided in the shape of a string.

7. The elongated actuator (100) according to any one of claims 1-5, **characterised in that** the actuating element (10) is provided in the form of an actuating sheet.

8. The elongated actuator (100) according to any one of the preceding claims, **characterised in that** a plurality of actuating elements (10) is provided inside the frame member (18).

9. The elongated actuator (100) according to any one of the preceding claims, **characterised in that** the frame member (18) has an elliptical cross section in the first state and a circular cross section in the second state.

10. The elongated actuator (100) according to any one of the preceding claims, **characterised in that** the frame member (18) has a rectangular cross section in at least one of the states.

11. The elongated actuator (100) according to any one of the claims 7-11 and 2, **characterised in that** the actuating sheet or the plurality of actuating sheets extend in the first direction.

12. The elongated actuator (100) according to any one of the claims 7-11 and 2, **characterised in that** the actuating sheet or the plurality of actuating sheets extend perpendicularly to the first direction.

13. The elongated actuator (100) according to any one of the preceding claims, **characterised in that** the actuating element comprises a pre-stretched dielectric elastomer actuator.

14. The elongated actuator (100) according to claim 13, **characterised in that** in the first state no voltage is applied to the dielectric elastomer actuator, and in the second state a voltage is applied to the dielectric elastomer actuator for releasing the strain inside the dielectric elastomer.

15. Elongated structure, comprising at least one elongated actuator (100) according to any one of the preceding claims.

16. Elongated structure according to claim 15, **characterised in that** it comprises an outer tube (200), in which the at least one elongated actuator (100) is situated.

17. Elongated structure (206) according to claim 15, **characterised in that** it is wing-shaped and that it comprises a wing portion (204), in which the at least one elongated actuator (100) is situated and which is adapted to be deformed by the at least one elongated actuator (100).

18. Use of an elongated actuator (100) according to any one of claims 1-14 in aerodynamics or hydrodynamics.

19. A method of producing an elongated actuator (100), comprising the following method steps:
• providing an elongated frame member (18) extending in a first direction;
• integrating an actuating element (10) inside the frame member (18) so that it is adapted to deform the frame member (18) and so that the frame member (18) encapsulates the actuating element (10),
wherein the actuating element (10) is pre-stretched prior to being integrated inside the frame member (18).

20. The method according to claim 19, **characterised in that** the frame member (18) is a tube made at least partially of an elastic material and that upon inserting the pre-stretched actuating element (10) the frame member (18) adopts an elliptical cross-section.

## Patentansprüche

1. Längliches Betätigungsglied (100), umfassend:
• ein Rahmenelement (18), wobei das Rahmenelement (18) ausgelegt ist, um zwischen wenigstens zwei Zuständen zu schalten, wobei das Rahmenelement (18) elastische Energie freisetzt, wenn es von einem ersten in einen zweiten Zustand schaltet, und elastische Energie speichert, wenn es vom zweiten in den ersten Zustand schaltet;
• wenigstens ein Antriebselement (10) innerhalb des Rahmenelements (18), wobei das Antriebselement (10) ein vorgespanntes Material umfasst und ausgelegt ist, um das Rahmenelement (18) zu verformen und einen Übergang zwischen den wenigstens zwei Zuständen zu verursachen, wobei das Antriebselement (10) sich in einem nicht aktivierten Zustand befindet, wenn sich das Rahmenelement (18) im ersten Zustand befindet, und in einem aktivierten Zustand befindet, wenn sich das Rahmenelement (18) im zweiten Zustand befindet,
**dadurch gekennzeichnet, dass** das Rahmenelement (18) länglich ist, um so das wenigstens eine Antriebs-element (10) einzukapseln.

2. Längliches Betätigungsglied (100) nach Anspruch 1, **dadurch gekennzeichnet, dass** das Rahmenelement (18) sich in eine erste Richtung erstreckt.

3. Längliches Betätigungsglied (100) nach Anspruch 1 oder 2, **dadurch gekennzeichnet, dass** das Rahmenelement (18) wenigstens einen Abschnitt umfasst, welcher aus einem elastischen Material hergestellt ist, wobei das Antriebselement (10) ausgelegt ist, den Abschnitt (18) zu verformen.

4. Längliches Betätigungsglied (100) nach einem beliebigen der Ansprüche 2-3, **dadurch gekennzeichnet, dass** das Antriebselement ausgelegt ist, um das Rahmenelement (18) in eine zweite Richtung senkrecht zur ersten Richtung zu verformen.

5. Längliches Betätigungsglied (100) nach einem beliebigen der vorangehenden Ansprüche, **dadurch gekennzeichnet, dass** das Rahmenelement (18) eine äußere Wand umfasst, wobei das Antriebselement (10) ausgelegt ist, um eine Kraft auf eine innere Fläche der äußeren Wand aufzubringen.

6. Längliches Betätigungsglied (100) nach einem beliebigen der vorangehenden Ansprüche, **dadurch gekennzeichnet, dass** das Antriebselement (10) in der Gestalt einer Schnur bereitgestellt ist.

7. Längliches Betätigungsglied (100) nach einem beliebigen der Ansprüche 1-5, **dadurch gekennzeichnet, dass** das Antriebselement (10) in der Form einer Antriebsplatte bereitgestellt ist.

8. Längliches Betätigungsglied (100) nach einem beliebigen der vorangehenden Ansprüche, **dadurch gekennzeichnet, dass** eine Mehrzahl von Antriebselementen (10) innerhalb des Rahmenelements (18) bereitgestellt ist.

9. Längliches Betätigungsglied (100) nach einem beliebigen der vorangehenden Ansprüche, **dadurch gekennzeichnet, dass** das Rahmenelement (18) einen elliptischen Querschnitt im ersten Zustand und einen runden Querschnitt im zweiten Zustand aufweist.

10. Längliches Betätigungsglied (100) nach einem beliebigen der vorangehenden Ansprüche, **dadurch gekennzeichnet, dass** das Rahmenelement (18) einen rechteckigen Querschnitt in wenigstens einem der Zustände aufweist.

11. Längliches Betätigungsglied (100) nach einem beliebigen der Ansprüche 7-11 und 2, **dadurch gekennzeichnet, dass** die Antriebsplatte oder die Mehrzahl der Antriebsplatten sich in die erste Richtung erstreckt.

12. Längliches Betätigungsglied (100) nach einem beliebigen der Ansprüche 7-11 und 2, **dadurch gekennzeichnet, dass** die Antriebsplatte oder die Mehrzahl der Antriebsplatten sich senkrecht zur ersten Richtung erstreckt.

13. Längliches Betätigungsglied (100) nach einem beliebigen der vorangehenden Ansprüche, **dadurch gekennzeichnet, dass** das Antriebselement ein vorgedehntes dielektrisches Elastomer-Betätigungsglied umfasst.

14. Längliches Betätigungsglied (100) nach Anspruch 13, **dadurch gekennzeichnet, dass** im ersten Zustand keine Spannung an das dielektrische Elastomer-Betätigungsglied angelegt ist und dass im zweiten Zustand eine Spannung an das dielektrische Elastomer-Betätigungsglied zum Freisetzen der Dehnung innerhalb des dielektrischen Elastomers angelegt ist.

15. Längliche Struktur, umfassend ein längliches Betätigungsglied (100) nach einem beliebigen der vorangehenden Ansprüche.

16. Längliche Struktur nach Anspruch 15, **dadurch gekennzeichnet, dass** sie ein äußeres Rohr (200) umfasst, in welchem das wenigstens eine längliche Betätigungsglied (100) angeordnet ist.

17. Längliche Struktur (206) nach Anspruch 15, **dadurch gekennzeichnet, dass** sie flügelförmig ist und dass sie einen Flügelabschnitt (204) umfasst, in welchem das wenigstens eine längliche Betätigungsglied (100) angeordnet ist und welcher ausgelegt ist durch das wenigstens eine längliche Betätigungsglied (100) verformt zu werden.

18. Einsatz eines länglichen Betätigungsgliedes (100) nach einem beliebigen der Ansprüche 1-14 in der Aerodynamik oder Hydrodynamik.

19. Verfahren zur Herstellung eines länglichen Betätigungsgliedes (100), umfassend die folgenden Verfahrensschritte:
• Bereitstellen eines länglichen Rahmenelements (18), welches sich in eine erste Richtung erstreckt;
• Einfügen eines Antriebselements (10) in das Rahmenelement (18), so dass es ausgelegt ist, das Rahmenelement (18) zu verformen, und so dass das Rahmenelement (18) das Antriebselement (10) verkapselt,
wobei das Antriebselement (10) vorgedehnt ist, bevor es im Rahmenelement (18) eingefügt wird.

20. Verfahren nach Anspruch 19, **dadurch gekennzeichnet, dass** das Rahmenelement (18) ein Rohr ist, welches wenigstens teilweise aus einem elastischen Material hergestellt ist, und dass beim Einfügen des vorgedehnten Antriebselements (10) das Rahmenelement (18) einen elliptischen Querschnitt annimmt.

## Revendications

1. Déclencheur allongé (100), comprenant:
• un élément de structure (18), l'élément de structure (18) étant adapté pour basculer entre au moins deux états, ou l'élément de structure (18) libère de l'énergie élastique en passant du second au premier état;
• au moins un organe de commande à l'intérieur (10) de l'élément de structure (18), l'organe de commande (10) comprenant un matériau prétendu et étant adapté pour déformer l'élément de structure (18) et causer une transition entre au moins les deux états, où l'organe de commande (10) est dans un état inactif, lorsque l'élément de structure (18) est dans le premier état, et est dans un état actif, lorsque l'élément de structure (18) est dans le second état,
**caractérisé en ce que** l'élément de structure (18) est allongé de manière à encapsuler au moins l'organe de commande (10).

2. Déclencheur allongé (100) conformément à la revendication 1, **caractérisé en ce que** l'élément de structure (18) s'étend dans une première direction.

3. Déclencheur allongé (100) conformément à la revendication 1 ou 2, **caractérisé en ce que** l'élément de structure (18) comprend au moins une partie faite d'un matériau élastique, l'organe de commande (10) étant adapté pour déformer ladite partie (18).

4. Déclencheur allongé (100) conformément à l'une quelconque des revendications 2-3, **caractérisé en ce que** l'organe de commande (10) est adapté pour déformer l'élément de structure (18) dans une seconde direction perpendiculaire à la première direction.

5. Déclencheur allongé (100) conformément à l'une quelconque des précédentes revendications, **caractérisé en ce que** l'élément de structure (18) comprend une paroi externe, l'organe de commande (10) étant adapté pour appliquer une force sur une surface interne de la paroi externe.

6. Déclencheur allongé (100) conformément à l'une quelconque des précédentes revendications, **caractérisé en ce que** l'organe de commande (10) est fourni sous la forme d'une chaîne.

7. Déclencheur allongé (100) conformément à l'une quelconque des revendications 1-5, **caractérisé en ce que** l'organe de commande (10) est fourni sous la forme d'une feuille d'actionnement.

8. Déclencheur allongé (100) conformément à l'une quelconque des précédentes revendications, **caractérisé en ce qu'**une pluralité d'organes de commande (10) est fournie à l'intérieur de l'élément de structure (18).

9. Déclencheur allongé (100) conformément à l'une quelconque des précédentes revendications, **caractérisé en ce que** l'élément de structure (18) possède une section transversale elliptique dans le premier état et une section transversale circulaire dans le second état.

10. Déclencheur allongé (100) conformément à l'une quelconque des précédentes revendications, **caractérisé en ce que** l'élément de structure (18) possède une section transversale rectangulaire dans au moins l'un des états.

11. Déclencheur allongé (100) conformément à l'une quelconque des revendications 7-11 et 2, **caractérisé en ce que** la feuille d'actionnement ou la pluralité de feuilles d'actionnement s'étende dans la première direction.

12. Déclencheur allongé (100) conformément à l'une quelconque des revendications 7-11 et 2, **caractérisé en ce que** la feuille d'actionnement ou la pluralité de feuilles d'actionnement s'étende perpendiculairement à la première direction.

13. Déclencheur allongé (100) conformément à l'une quelconque des précédentes revendications, **caractérisé en ce que** l'organe de commande comprend un déclencheur élastomère diélectrique prétendu.

14. Déclencheur allongé (100) conformément à la revendication 13, **caractérisé en ce que** dans le premier état, aucune tension n'est appliqué au déclencheur élastomère diélectrique, et dans le second état, une tension est appliquée au déclencheur élastomère diélectrique pour libérer la pression à l'intérieur de l'élastomère diélectrique.

15. Structure allongée, comprenant au moins un déclencheur allongé (100) conformément à l'une des précédentes revendications.

16. Structure allongée conformément à la revendication 15, **caractérisée en ce qu'**elle comprend un tube externe (200), dans lequel est situé au moins un déclencheur allongé (100).

17. Structure allongée (206) conformément à la revendication 15, **caractérisée en ce qu'**elle a la forme d'une aile et qu'elle comprend une portion d'aile (204), dans laquelle au moins un déclencheur allongé (100) est situé et qui est adaptée pour être déformée par au moins un déclencheur allongé (100).

18. Utilisation d'un déclencheur allongé (100) conformément à l'une quelconque des revendications 1 - 14 en aérodynamique ou en hydrodynamique.

19. Procédé de fabrication d'un déclencheur allongé (100), comprenant les étapes suivantes:
• fournir un élément de structure allongé (18), s'étendant dans une première direction;
• intégrer un organe de commande (10) dans l'élément de structure (18) de manière à ce qu'il soit adapté pour déformer l'élément de structure (18) et de manière à ce que l'élément de structure (18) encapsule l'organe de commande (10),
où l'organe de commande (10) est prétendu avant d'être intégré dans l'élément de structure (18).

20. Procédé conformément à la revendication 19, **caractérisé en ce que** l'élément de structure (18) est un tube comprenant au moins en partie un matériau élastique et que sur insertion de l'organe de commande prétendu (10), l'élément de structure (18) adopte une section transversale elliptique.
